# EUROPEAN PATENT APPLICATION

(11) **EP 4 636 306 A1**
(43) Date of publication of application: **22.10.2025**
(21) Application number: 23903350.9
(22) Date of filing: 05.12.2023
(51) Int. Cl.: F21V 13/04, B60K 35/23, G02B 3/00, G02B 3/02, G02B 5/09, G02B 5/10, G02B 27/01, H01L 33/58, H01L 33/60, H10K 50/858, H10K 59/00, F21Y 115/10

(54) **OPTICAL MEMBER, ILLUMINATION DEVICE, AND IMAGE PROJECTION DEVICE**

(30) Priority: 15.12.2022 JP 2022200646
(71) Applicant: Koito Manufacturing Co., Ltd., Shinagawa-ku, Tokyo 141-0001 (JP)
(72) Inventor: NOMURA, Keiichiro, Shizuoka-shi, Shizuoka 424-8764 (JP); TOYOSHIMA, Takanobu, Shizuoka-shi, Shizuoka 424-8764 (JP)
(74) Representative: Hoffmann Eitle
(86) International application number: PCT/JP2023/043386
(87) International publication number: WO 2024/128061

(57) **Abstract**

Provided are an optical member, an illumination device, and an image projection device, which are capable of uniformly irradiating a limited display region with irradiation light and increasing the use efficiency of the irradiation light. An optical member (100) comprises: a reflection part (10) that has a reflection surface (12) formed on the inner surface thereof, and that has a light entering opening (17) opened at one end of the reflection surface (12) and a light emission opening (16) opened at the other end of the reflection surface (12); and a lens part (20) disposed on the light emission opening (16) of the reflection part (10). The lens part (20) has a center region (21) located on the center, and a circumferential edge region (22) provided around the center region (21). The optical power of the center region (21) is greater than that of the circumferential edge region (22).

## Description

### TECHNICAL FIELD

The present invention relates to an optical member, an illumination device, and an image projection device.

### BACKGROUND ART

In the related art, an instrument panel for lighting and displaying an icon is used as a device for displaying various kinds of information in a vehicle. Due to an increase in an amount of information to be displayed, it has also been proposed to embed an image display device in the instrument panel or to form the entire instrument panel with the image display device.

Since the instrument panel is positioned below a front glass (windshield) of the vehicle, for a driver or other occupants to visually recognize the information displayed on the instrument panel, it is necessary to move the line of sight downward while driving, which is undesirable. There has been proposed an image projection device such as a head up display (hereinafter, referred to as HUD) configured to project an image onto a front glass so that an occupant can read information when visually recognizing the front of the vehicle (for example, see Patent Literature 1 or 2).

The image projection device according to Patent Literature 1 or 2 emits irradiation light including the image by an image display unit, reflects the irradiation light by a free-form surface mirror or the like, and causes the irradiation light to reach a position of a viewpoint of the occupant so that the image is formed in a space via a display unit such as the windshield. Accordingly, the occupant can recognize that the image is displayed at an image forming position in a depth direction by the irradiation light incident on the viewpoint.

### CITATION LIST

### PATENT LITERATURE

Patent Literature 1: JP2019-119248A
Patent Literature 2: JP2019-119262A

### SUMMARY OF INVENTION

### TECHNICAL PROBLEM

In a related image projection device, a liquid crystal display device or the like is used as an image display unit to display a projection image, and irradiation light is emitted from an illumination device onto a display region (irradiation region) of an image in the image display unit to project image light. In general, in an in-vehicle image projection device, a size of a display region is limited in order to present necessary information without interfering with a field of view, and in particular, a size in a height direction is limited and the display region is long in a horizontal direction. Therefore, the illumination device of the image projection device is required to uniformly irradiate the entire horizontally long display region.

However, when it is attempted to make the irradiation light from the illumination device uniform in the horizontal direction, there is a problem that a light diameter also increases in the height direction, the amount of light reaching regions outside the display region increases, and the use efficiency of the light emitted from a light source decreases. In particular, in a case in which a plurality of light emitting elements such as light emitting diodes (LEDs) are arranged as a light source of the illumination device, it is difficult to achieve both uniform irradiation of light between the plurality of LEDs and improvement of light use efficiency in the height direction.

Therefore, the present invention has been made in view of the above related problems, and an object of the present invention is to provide an optical member, an illumination device, and an image projection device capable of uniformly irradiating a limited display region with irradiation light and increasing the use efficiency of the irradiation light.

### SOLUTION TO PROBLEM

In order to solve the above problems, an optical member according to the present invention includes: a reflecting portion including a reflecting surface formed on an inner surface thereof, the reflecting portion having a light incident port opened at one end of the reflecting surface and a light emission port opened at another end of the reflecting surface; and a lens portion disposed at the light emission port of the reflecting portion, in which the lens portion includes a central region positioned at a center and a peripheral region provided around the central region, and an optical power of the central region is larger than that of the peripheral region.

In such an optical member according to the present invention, since the lens portion is disposed at the light emission port of the reflecting portion and the optical power of the central region of the lens portion is larger than that of the peripheral region, it is possible to set a region irradiated with light directly incident on the central region and the peripheral region from a light source and a region irradiated with light reflected by the reflecting portion and incident on the peripheral region, respectively. Accordingly, it is possible to uniformly irradiate a limited display region with irradiation light and increase the use efficiency of the irradiation light.

In one aspect of the present invention, a distance D between the light emission port and the central region and a width Wₒᵤₜ of the light emission port satisfy a relation of D ≤ 0.5 Wₒᵤₜ.

In one aspect of the present invention, the central region has a convex lens shape in which a light incident surface protrudes toward the reflecting portion.

In one aspect of the present invention, at least a part of the light incident surface is inserted so as to be situated on a light incident port side relative to the light emission port.

In one aspect of the present invention, a width W_{c} of the central region and a width Wₒᵤₜ of the light emission port satisfy a relation of 0.3 Wₒᵤₜ ≤ W_{c} ≤ 0.7 Wₒᵤₜ.

In one aspect of the present invention, the reflecting surface has a polygonal cross section.

In one aspect of the present invention, a plurality of sets, each of the plurality of sets including the reflecting portion and the lens portion, are provided, and the plurality sets of reflecting portions and lens portions are connected and arranged in a uniaxial direction.

In order to solve the above problems, an illumination device according to the present invention includes: the optical member according to any one of the above; and a light emitting element disposed on a light incident port side and configured to emit light, in which a width W_{d} of the light emitting element and a width Wᵢₙ of the light incident port satisfy a relation of W_{d} < Wᵢₙ.

In order to solve the above problems, an image projection device according to the present invention includes: an image display unit configured to display an image by being irradiated with the light from the illumination device; and a projection optical unit configured to project the light from the image display unit.

### ADVANTAGEOUS EFFECTS OF INVENTION

According to the present invention, it is possible to provide an optical member, an illumination device, and an image projection device capable of uniformly irradiating a limited display region with irradiation light and increasing the use efficiency of the irradiation light.

### BRIEF DESCRIPTION OF DRAWINGS

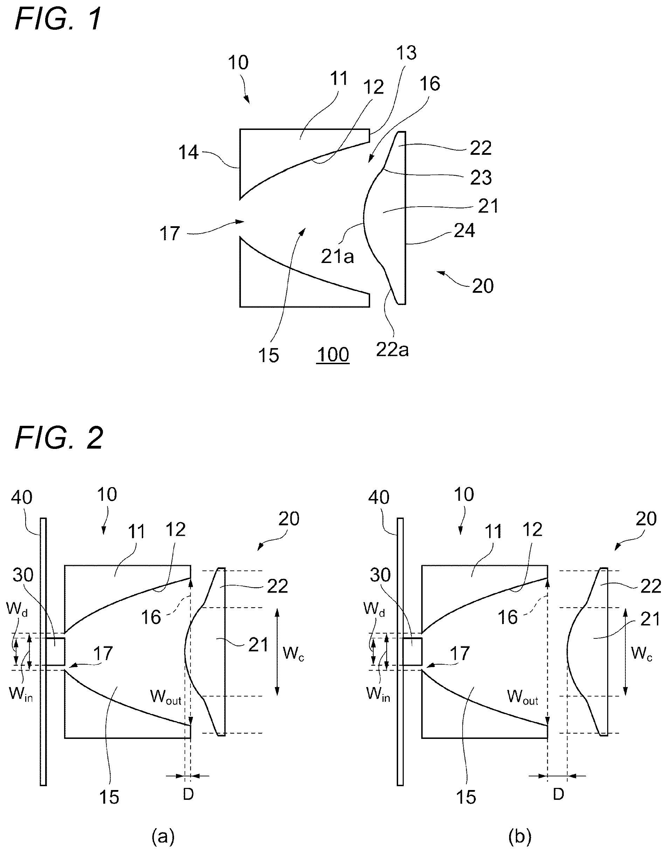

[Fig. 1] Fig. 1 is a schematic cross-sectional view illustrating an outline of an optical member 100 according to a first embodiment.
[Fig. 2] Fig. 2 shows schematic cross-sectional views each illustrating an outline of an illumination device according to the first embodiment, in which (a) of Fig. 2 illustrates an example in which a lens portion 20 is inserted and arranged inside a light emission port 16, and (b) of Fig. 2 illustrates an example in which the lens portion 20 is arranged apart from the light emission port 16.

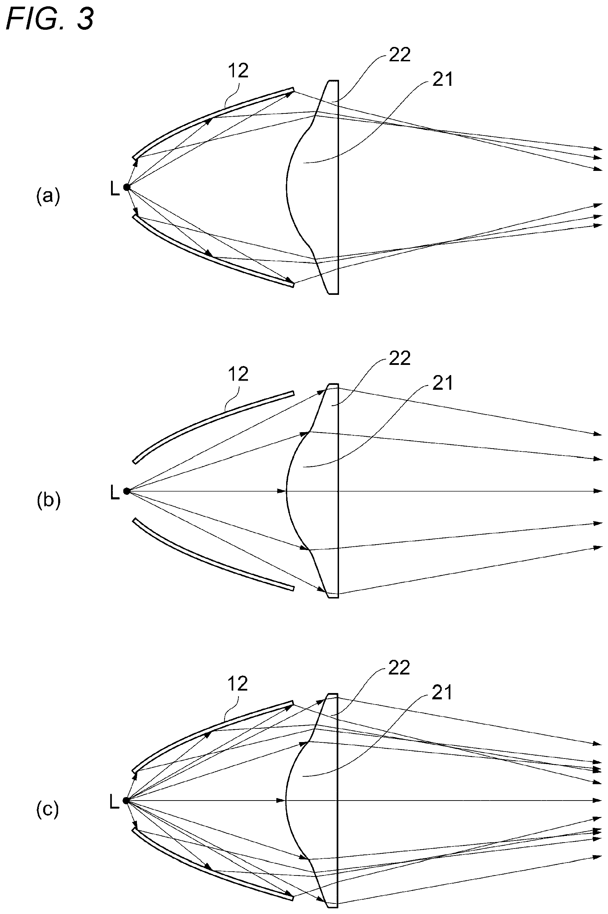

[Fig. 3] Fig. 3 shows schematic views each illustrating a light irradiation region in the optical member 100, in which (a) of Fig. 3 schematically illustrates optical paths through a peripheral region 22, (b) of Fig. 3 schematically illustrates optical paths through a central region 21, and (c) of Fig. 3 schematically illustrates the entire optical paths.

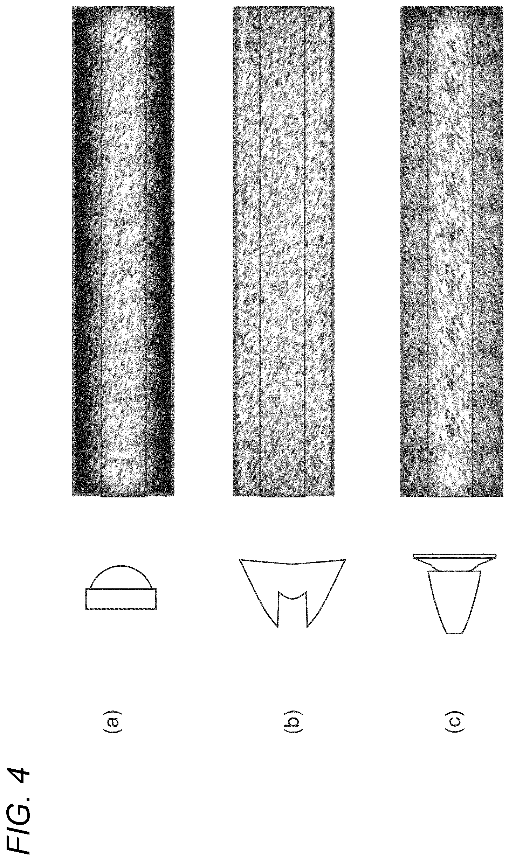

[Fig. 4] Fig. 4 shows diagrams each illustrating a light irradiation region in a comparative example or an example, in which (a) of Fig. 4 illustrates Comparative Example 1 in which only a lens is used, (b) of Fig. 4 illustrates Comparative Example 2 in which only a TIR lens is used, and (c) of Fig. 4 illustrates an example in which the optical member 100 according to the first embodiment is used.

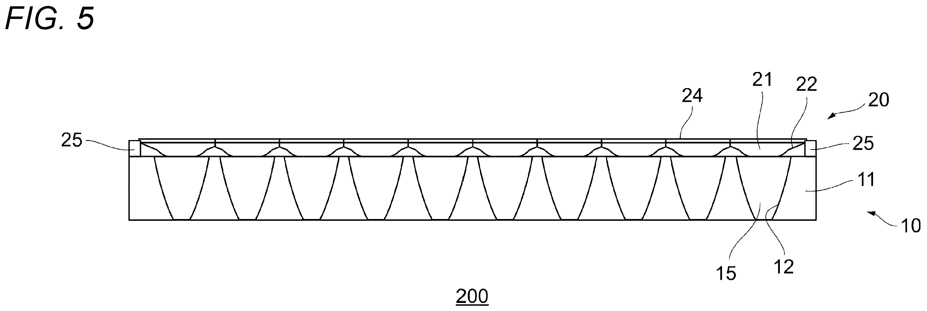

[Fig. 5] Fig. 5 is a schematic cross-sectional view illustrating an outline of an optical member 200 according to a second embodiment.

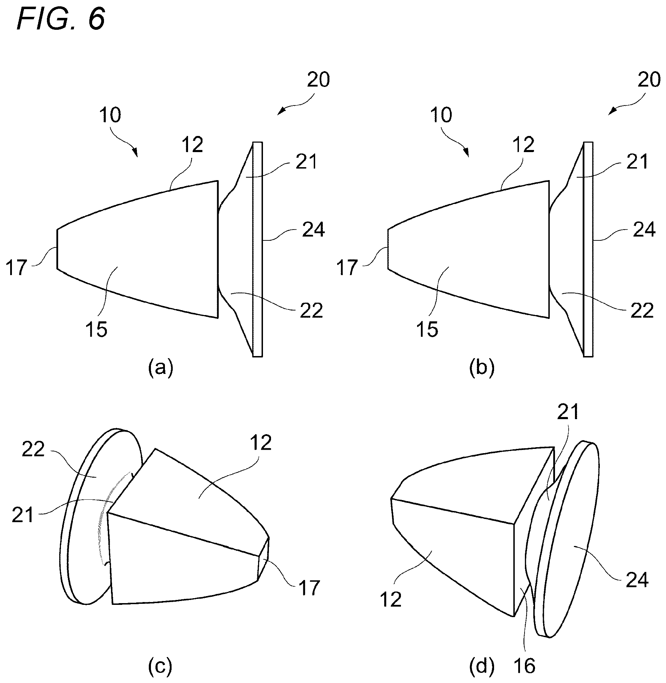

[Fig. 6] Fig. 6 shows schematic diagrams each illustrating only shapes of a reflecting surface 12 and a cavity 15 in the optical member 100 according to a third embodiment with a body portion 11 omitted, in which (a) of Fig. 6 is a side view, (b) of Fig. 6 is a top view, (c) of Fig. 6 is a perspective view from a light incident port 17 side, and (d) of Fig. 6 is a perspective view from a light emission surface 24 side.

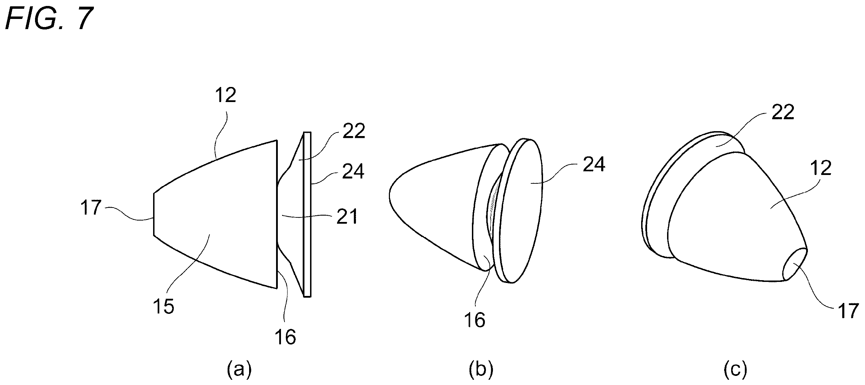

[Fig. 7] Fig. 7 shows schematic diagrams each illustrating only the shapes of the reflecting surface 12 and the cavity 15 in the optical member 100 according to a fourth embodiment with the body portion 11 omitted, in which (a) of Fig. 7 is a side view, (b) of Fig. 7 is a perspective view from the light emission surface 24 side, and (c) of Fig. 7 is a perspective view from the light incident port 17 side.

### DESCRIPTION OF EMBODIMENTS

### (First Embodiment)

Hereinafter, embodiments of the present invention will be described in detail with reference to the drawings. The same or equivalent components, members, and processing illustrated in the drawings are denoted by the same reference signs, and redundant description thereof will be omitted as appropriate. Fig. 1 is a schematic cross-sectional view illustrating an outline of an optical member 100 according to the present embodiment. As illustrated in Fig. 1, the optical member 100 includes a reflecting portion 10 and a lens portion 20.

The reflecting portion 10 is a portion that reflects light emitted from a light source and causes the light to reach a part of the lens portion 20. As illustrated in Fig. 1, the reflecting portion 10 includes a body portion 11, a reflecting surface 12, a top surface 13, a bottom surface 14, a cavity 15, a light emission port 16, and a light incident port 17. The lens portion 20 is disposed on a light emission port 16 side of the reflecting portion 10.

The body portion 11 constitutes an outer shape of the reflecting portion 10, and has the cavity 15 formed therein and the reflecting surface 12 formed on an inner surface thereof. Fig. 1 illustrates a cross-sectional view along a width direction of the optical member 100, the body portion 11 is formed to extend in a direction perpendicular to the paper surface, and a plurality of the cavities 15 are provided in the direction perpendicular to the paper surface. Although Fig. 1 illustrates the body portion 11 having a thick block shape, the shape and structure of the body portion 11 are not limited thereto, and the body portion 11 may have a thin structure along the reflecting surface 12. Further, the material constituting the body portion 11 is not limited, and may be a transparent or non-transparent resin material, or may be a ceramic material or a metal material.

The reflecting surface 12 is a curved surface portion that is formed on the inner surface of the body portion 11 and reflects a part of light incident from the light incident port 17. The reflecting surface 12 has a paraboloidal shape, an ellipsoidal shape, or a free-form surface shape in a cross section along a light irradiation axis direction (left-right direction in the drawing). The reflecting surface 12 may be formed as a rotation surface centered on a light irradiation direction, or may be formed by extending a curved surface shape in a depth direction and an up-down direction with respect to the paper surface. The cavity 15 is formed inside the reflecting surface 12, the light emission port 16 is provided on a top surface 13 side, and the light incident port 17 is provided on a bottom surface 14 side. The reflecting surface 12 may be configured to reflect light by performing mirror finishing on the inner surface of the material constituting the body portion 11, or a reflecting film such as a metal film having high reflectivity may be formed on the inner surface of the body portion 11 using a vapor deposition method or a plating method.

The top surface 13 is a surface constituting a light emission side of the body portion 11. The bottom surface 14 is a surface constituting a light incident side of the body portion 11. The cavity 15 is a recess provided inside the body portion 11, the top surface 13 side communicates with the light emission port 16, and a bottom surface side communicates with the light incident port 17. The light emission port 16 is an opening provided on a light emission side of the reflecting surface 12. The light incident port 17 is an opening provided on a light incident side of the reflecting surface 12. Although not illustrated in Fig. 1, a holding portion for holding the lens portion 20 may be provided on the top surface 13. The bottom surface 14 may also be provided with a fixing portion for mounting and fixing the optical member 100 to a mounting substrate 40 described later.

The lens portion 20 is a portion that is disposed at the light emission port 16 of the reflecting portion 10, on which light emitted from the light source and light reflected by the reflecting portion 10 are incident, and refracts and transmits each light. As illustrated in Fig. 1, the lens portion 20 includes a central region 21, a peripheral region 22, light incident surfaces 21a and 22a, a boundary portion 23, and a light emission surface 24. The material constituting the lens portion 20 is not limited, and a known resin material or glass material can be used as long as visible light can be satisfactorily transmitted and refracted.

The central region 21 is a region positioned at the center of the lens portion 20, and is set to have a larger optical power than the peripheral region 22. A reflecting portion 10 side of the central region 21 is the light incident surface 21a, and a side opposite to the reflecting portion 10 is the light emission surface 24. In Fig. 1, the central region 21 is illustrated as having a convex lens shape in which the light incident surface 21a protrudes toward the light emission port 16, but the surface shape of the lens is not limited as long as the central region 21 is positioned at the center of the lens portion 20 and satisfies the condition that the optical power is larger than that of the peripheral region 22. As an example, the light emission surface 24 may be a convex lens protruding in a light emission direction (right direction in the drawing), or may be a meniscus lens.

The peripheral region 22 is a region provided around the central region 21, and is set to have a smaller optical power than the central region 21. A reflecting portion 10 side of the peripheral region 22 is the light incident surface 22a, and a side opposite to the reflecting portion 10 is the light emission surface 24. In Fig. 1, the peripheral region 22 is illustrated as having a convex lens shape in which an outermost periphery is thin and the thickness increases toward the central region 21 and protrudes toward the light emission port 16, but the surface shape of the lens is not limited as long as the peripheral region 22 is provided on an outer peripheral side relative to the central region 21 and satisfies the condition that the optical power is smaller than that of the central region 21. As an example, the light emission surface 24 may be a convex lens that becomes thicker from the outermost periphery toward the central region 21 and protrudes in the light emission direction, or may be a meniscus lens.

The boundary portion 23 is a portion constituting a boundary between the central region 21 and the peripheral region 22. In Fig. 1, the boundary portion 23 is illustrated as a region curved on the surface due to a discontinuous change in curvature between the central region 21 and the peripheral region 22, whereas the curvature may also change gradually between the central region 21 and the peripheral region 22. When the curvature gradually changes, the boundary between the central region 21 and the peripheral region 22 is unclear, and the optical powers of both regions gradually change. In this case, an inflection point in the change of the optical power or the middle between a maximum value and a minimum value of the optical power can be regarded as the boundary portion 23.

The light emission surface 24 is a surface constituting a light emission side of the lens portion 20. In Fig. 1, the light emission surface 24 is illustrated as a single flat surface on the light emission sides of the central region 21 and the peripheral region 22, but the surface shape of the light emission surface 24 is not limited thereto. As an example, the light emission sides of the central region 21 and the peripheral region 22 may intersect at different angles, or may be formed in different curved surface shapes.

Fig. 2 shows schematic cross-sectional views each illustrating an outline of an illumination device according to the first embodiment, in which (a) of Fig. 2 illustrates an example in which the lens portion 20 is inserted and arranged inside the light emission port 16, and (b) of Fig. 2 illustrates an example in which the lens portion 20 is arranged apart from the light emission port 16. As illustrated in Fig. 2, the illumination device includes the reflecting portion 10 and the lens portion 20 constituting the optical member 100, light emitting elements 30, and the mounting substrate 40. The illumination device illustrated in Fig. 2 is used in an image projection device including an image display unit for displaying an image and a projection optical unit for projecting light from the image display unit.

In the image projection device, light emitted from the illumination device is emitted to a display region of the image display unit, and an image displayed in the display region is projected by the projection optical unit. The image projection device is stored in, for example, a dashboard of a vehicle in a head up display (HUD), and a virtual image is formed by projecting a video from the image projection device via a windshield or the like. Light emitted from the image projection device is reflected by a projection optical unit such as a plane mirror or a free-form surface mirror as necessary, and is visually recognized by being guided to eyes of a driver via a windshield.

The light emitting element 30 is a member that is disposed on a light incident port 17 side of the reflecting portion 10 and irradiates the reflecting portion 10 and the lens portion 20 with light. The light emitting elements 30 are, for example, semiconductor light emitting elements such as light emitting diodes (LEDs), and are arranged in a predetermined direction (a direction perpendicular to the paper surface of Fig. 2). An emission color of the light emitting element 30 is not particularly limited, and is white as an example in the present embodiment. In the present embodiment, the light emitting elements 30 are arranged in one row, but may be arranged in two or more rows, or may be arranged so as to draw an arc or a curve instead of a linear arrangement, and the lens shape and the arrangement of the reflecting portion 10 may correspond to the arrangement shape of the LEDs. The light emitting element 30 is not limited to an LED and may be an organic electro luminescence (EL) element or the like.

The mounting substrate 40 is a member for mounting the light emitting element 30 and supplying power to the light emitting element 30. Although not illustrated in Fig. 2, wiring is formed on the surface or inside of the mounting substrate 40, and a plurality of electronic components and terminal portions may be mounted on the mounting substrate 40. In addition, a drive circuit of the light emitting element 30 may be implemented by the wiring and the electronic components. Power and a control signal are transmitted to the mounting substrate 40 from the outside via the terminal portion, and the light emitting element 30 emits light based on the control signal.

Of light emitted from the light emitting element 30, light traveling in the light emission direction enters the cavity 15 from the light incident port 17, travels in the cavity 15, and is incident on the light incident surface 21a of the central region 21 and the light incident surface 22a of the peripheral region 22. Further, of light emitted from the light emitting element 30, light traveling obliquely with respect to the light emission direction enters the cavity 15 from the light incident port 17, reaches the reflecting surface 12 of the reflecting portion 10, and is reflected. The light reflected by the reflecting surface 12 travels in the cavity 15 and is incident on the light incident surface 22a of the peripheral region 22. The light incident on the light incident surfaces 21a and 22a is refracted by the optical powers of the central region 21 and the peripheral region 22, and is emitted from the light emission surface 24 in a light irradiation direction.

As illustrated in Fig. 2, a width W_{d} of a light emitting surface of the light emitting element 30 is smaller than a width Wᵢₙ of the light incident port 17, and preferably satisfies a relation of W_{d} < Wᵢₙ. Although Fig. 2 illustrates an example in which an upper end surface of the light emitting element 30 is substantially the same as the position of the bottom surface 14 of the reflecting portion 10, the light emitting element 30 may be inserted and disposed in the cavity 15 from the light incident port 17. When the widths of the light emitting element 30 and the light incident port 17 satisfy the relation of W_{d} < Wᵢₙ, light emitted from the light emitting element 30 can be efficiently taken into the cavity 15. Here, the width W_{d} of the light emitting surface of the light emitting element 30 corresponds to a chip size when the light emitting element 30 is an LED chip, and corresponds to a width of a light emission surface such as a lens portion or a window portion when the light emitting element 30 is an LED package.

As illustrated in Fig. 2, a width W_{c} of the central region 21 is smaller than a width Wₒᵤₜ of the light emission port 16 and preferably satisfies a relation of W_{c} ≤ Wₒᵤₜ. Further, the relation between the width W_{c} of the central region 21 and the width Wₒᵤₜ of the light emission port 16 more preferably satisfies 0.3 Wₒᵤₜ ≤ W_{c} ≤ 0.7 Wₒᵤₜ. When W_{c} is smaller than this range, the amount of light refracted in the central region 21 decreases, the amount of light in the vicinity of the center in an irradiation region cannot be ensured, and uniform light irradiation becomes difficult. When W_{c} is larger than this range, the amount of light reflected by the reflecting surface 12 and refracted by the peripheral region 22 decreases, and the amount of light in the vicinity of the outer periphery in the irradiation region cannot be ensured, and uniform light irradiation becomes difficult.

In the example illustrated in (a) of Fig. 2, the central region 21 has a convex lens shape in which the light incident surface 21a protrudes toward the reflecting portion 10, and at least a part of the light incident surface 21a is inserted into the cavity 15 (so as to be situated on the light incident port 17 side) relative to the light emission port 16 in the cavity 15. In other words, when the light emission direction is positive and a light incident direction is negative with respect to the position of the top surface 13 of the light emission port 16, a distance D between a position of a most protruding portion of the light incident surface 21a and the position of the top surface 13 has a negative value. By inserting the light incident surface 21a into the cavity 15, the central region 21 and the peripheral region 22 can be disposed close to the light emitting element 30, making it easier to limit an irradiation range of light.

In the example illustrated in (b) of Fig. 2, the central region 21 has a convex lens shape in which the light incident surface 21a protrudes toward the reflecting portion 10, and a distal end of the light incident surface 21a and the light emission port 16 are disposed apart from each other by the distance D. In other words, the distance D between the position of the most protruding portion of the light incident surface 21a and the position of the top surface 13 has a positive value. Since the light incident surface 21a and the light emission port 16 are disposed apart from each other, it is possible to ensure a wider area of the central region 21. The distance D between the distal end of the light incident surface 21a of the central region 21 and the light emission port 16 preferably satisfies a relation of D ≤ 0.5 Wₒᵤₜ. When the distance D is larger than this range, light emitted from the light emitting element 30 and traveling in the cavity 15 spreads too much, making it difficult to uniformly irradiate a limited small range with the light.

Fig. 3 shows schematic views each illustrating the light irradiation region in the optical member 100, in which (a) of Fig. 3 schematically illustrates optical paths through the peripheral region 22, (b) of Fig. 3 schematically illustrates optical paths through the central region 21, and (c) of Fig. 3 schematically illustrates the entire optical paths. A point L in the drawing indicates a light emission center of the light emitting element 30, and represents a light irradiation position when the light emitting element 30 is regarded as a point light source. The actual light emitting element 30 has a light emitting surface with a finite area, but in Fig. 3, the point light source is used for convenience of description. Arrows illustrated in the drawings indicate optical paths along which light travels, but the arrows are drawn in a simplified manner to schematically illustrate the optical paths, and the density of the arrows does not accurately represent the amount of light or luminance. In addition, refraction of light in the lens portion 20 is also schematically illustrated, and does not accurately indicate refraction of light.

As illustrated in (a) of Fig. 3, of light emitted from the light emitting element 30, light traveling in a direction inclined at an angle larger than a predetermined angle with respect to the light emission direction (right direction in the drawing) is incident on the reflecting surface 12 and reflected. The light reflected by the reflecting surface 12 travels in the cavity 15 and is incident on the peripheral region 22. The light incident on the peripheral region 22 is the light reflected by the reflecting surface 12, and an incident angle when the light reaches the light incident surface 22a varies depending on the shape and position of the reflecting surface 12. Although the peripheral region 22 has an optical power smaller than that of the central region 21, since the peripheral region 22 has a positive optical power, light is slightly focused toward the center of the irradiation region.

As illustrated in (b) of Fig. 3, of light emitted from the light emitting element 30, light traveling in a direction inclined by an angle smaller than the predetermined angle with respect to the light emission direction travels in the cavity 15 and is directly incident on the light incident surface 21a of the central region 21 and the light incident surface 22a of the peripheral region 22. The light directly incident on the light incident surfaces 21a and 22a from the light emitting element 30 spreads radially from the point L. Here, since the optical power of the peripheral region 22 is smaller than that of the central region 21, the light incident on the light incident surface 22a is slightly focused. In addition, the light incident on the light incident surface 21a is focused with an optical power larger than that of the peripheral region 22, but is slightly focused because the incident angle when the light reaches the light incident surface 21a is small.

As illustrated in (c) of Fig. 3, the light reflected by the reflecting surface 12 and incident on the light incident surface 22a and the light directly incident on the light incident surfaces 21a and 22a are emitted in a superimposed manner. As described above, the light incident on the light incident surface 21a is refracted and focused with a relatively large optical power, and the light incident on the light incident surface 22a is refracted and focused with a relatively small optical power. Since the light emitted from the light emitting element 30 generally has a light distribution close to a Gaussian distribution, the center and the outer periphery of the irradiation region can be uniformly irradiated with light by appropriately setting the optical power relation between the central region 21 and the peripheral region 22.

Fig. 3 illustrates an example in which light reflected by the reflecting surface 12 is incident on the light incident surface 22a at different angles, and an example in which light refracted by the peripheral region 22 intersects. However, when the reflecting surface 12 has a paraboloidal shape, the point light source L can be disposed at a focal position of the parabolic surface, so that the light reflected by the reflecting surface 12 can be incident on the light incident surface 22a as substantially parallel light. This makes it easy to irradiate the irradiation region with light refracted by the peripheral region 22 at an appropriate density. In addition, when the reflecting surface 12 is implemented as a free-form surface mirror, the shape of the reflecting surface 12 can be set to achieve an appropriate light distribution by using an emission port from the light emitting element 30 as a light emitting surface having a finite area instead of the point light source L.

Fig. 4 shows diagrams each illustrating a light irradiation region in a comparative example or an example, in which (a) of Fig. 4 illustrates Comparative Example 1 in which only a lens is used, (b) of Fig. 4 illustrates Comparative Example 2 in which only a TIR lens is used, and (c) of Fig. 4 illustrates an example in which the optical member 100 according to the first embodiment is used. The schematic diagrams illustrated on the left side in the figure each illustrate the shape of the lens, and the photographs illustrated on the right side each illustrate light beams emitted to the image display unit of the image projection device. A region surrounded by a black solid line in each photograph illustrated on the right side corresponds to the irradiation region (display region) in which an image is displayed and light is emitted. In the following, a relative light beam will be described with the light beam of the entire image display unit and the irradiation region of Comparative Example 2, which uses the TIR lens, set as a reference (100%).

In Comparative Example 1 using only the convex lens illustrated in (a) of Fig. 4, the light beam of the entire image display unit was 43.7%, and the light beam of the irradiation region was 86.9%. In Comparative Example 1, since light is focused by the convex lens, the light beam can be concentrated on the irradiation region, but light emitted from the light emitting element 30 in an outward direction cannot be effectively used. Therefore, it is difficult to improve the luminance and visibility of a virtual image projected by the image projection device.

In Comparative Example 2 using the TIR lens illustrated in (b) of Fig. 4, the entire image display unit can be uniformly irradiated with light, but a region outside the irradiation region is also irradiated with a large amount of light. This is because the reflecting surface of the TIR lens uses total reflection due to a refractive index difference, and there is a physical limit to an inclination angle and a size of the reflecting surface. Therefore, in Comparative Example 2 using the TIR lens, it is difficult to concentrating the light beam on the irradiation region which is a narrow range to improve the luminance and visibility of the virtual image.

In the example using the optical member 100 according to the first embodiment illustrated in (c) of Fig. 4, the light beam of the entire image display unit is 97.5%, and the light beam of the irradiation region is 169%. Therefore, in Example 1, the luminance and visibility of the virtual image can be improved by concentrating the light beam on the irradiation region which is a range narrower than that of Comparative Example 2. Further, from the photograph illustrated on the right side in (c) of Fig. 4, it can be seen that the irradiation light can be uniformly emitted to the limited irradiation region (display region), and the use efficiency of the irradiation light can be improved.

As described above, in the optical member 100, the illumination device, and the image projection device according to the present embodiment, since the lens portion 20 is disposed at the light emission port 16 of the reflecting portion 10 and the optical power of the central region 21 of the lens portion 20 is larger than that of the peripheral region 22, it is possible to set a region irradiated with light directly incident on the central region 21 and the peripheral region 22 from the light emitting element 30 and a region irradiated with light reflected by the reflecting portion 10 and incident on the peripheral region 22, respectively. Accordingly, it is possible to uniformly irradiate a limited display region with irradiation light and increase the use efficiency of the irradiation light.

### (Second Embodiment)

Next, a second embodiment of the present invention will be described with reference to Fig. 5. Description of contents overlapping the first embodiment will be omitted. Fig. 5 is a schematic cross-sectional view illustrating an outline of an optical member 200 according to the present embodiment. The optical member 200 includes a plurality sets each including the reflecting portion 10 and the lens portion 20, and the plurality of sets of reflecting portions 10 and lens portions 20 are integrally formed and arranged by being connected in a uniaxial direction (left-right direction in the drawing). At both ends of the reflecting portion 10, lens holding portions 25 are erected on the top surface 13, and at both ends of the lens portion 20, the peripheral region 22 is held by the lens holding portions 25. Further, in the optical member 200, the adjacent peripheral regions 22 of the lens portion 20 are integrally formed, and the light emission surface 24 constitutes a single flat surface as a whole.

Also in the present embodiment, in the optical member 100, the illumination device, and the image projection device according to the present embodiment, since the lens portion 20 is disposed at the light emission port 16 of the reflecting portion 10 and the optical power of the central region 21 of the lens portion 20 is larger than that of the peripheral region 22, it is possible to set a region irradiated with light directly incident on the central region 21 and the peripheral region 22 from the light emitting element 30 and a region irradiated with light reflected by the reflecting portion 10 and incident on the peripheral region 22, respectively. Accordingly, it is possible to uniformly irradiate a limited display region with irradiation light and increase the use efficiency of the irradiation light.

### (Third Embodiment)

Next, a third embodiment of the present invention will be described with reference to Fig. 6. Description of contents overlapping the first embodiment will be omitted. Fig. 6 shows schematic diagrams each illustrating only shapes of the reflecting surface 12 and the cavity 15 in the optical member 100 according to the present embodiment with the body portion 11 omitted, in which (a) of Fig. 6 is a side view, (b) of Fig. 6 is a top view, (c) of Fig. 6 is a perspective view from the light incident port 17 side, and (d) of Fig. 6 is a perspective view from a light emission surface 24 side.

As illustrated in (a) to (d) of Fig. 6, in the present embodiment, the reflecting surface 12 of the reflecting portion 10 is implemented with four curved surfaces, and the reflecting surface 12 has a square shape in a cross section perpendicular to a light emission direction. Since the cross section of the reflecting surface 12 is square, the area of the light emission port 16 can be increased, the density when arranging the plurality of optical members 100 can be improved, thereby increasing the aperture ratio of the light emission port 16 and improving the light use efficiency. Although Fig. 6 illustrates an example in which the cross section of the reflecting surface 12 is a square, if the cross section of the reflecting surface 12 has a polygonal shape such as a triangle or a hexagon, it is possible to improve the density when arranging the plurality of optical members 100.

### (Fourth Embodiment)

Next, a fourth embodiment of the present invention will be described with reference to Fig. 7. Description of contents overlapping the first embodiment will be omitted. Fig. 7 shows schematic diagrams each illustrating only the shapes of the reflecting surface 12 and the cavity 15 in the optical member 100 according to the present embodiment with the body portion 11 omitted, in which (a) of Fig. 7 is a side view, (b) of Fig. 7 is a perspective view from the light emission surface 24 side, and (c) of Fig. 7 is a perspective view from the light incident port 17 side.

As illustrated in (a) to (c) of Fig. 7, in the present embodiment, the reflecting surface 12 of the reflecting portion 10 is implemented with a rotational curved surface having a light emission direction as a central axis, and the reflecting surface 12 has a circular shape in a cross section perpendicular to the light emission direction. Since the cross section of the reflecting surface 12 is circular, light emitted from the light emitting element 30 can be uniformly emitted around the central axis.

The present invention is not limited to the embodiments described above, and various modifications can be made within the scope of the claims. Embodiments obtained by appropriately combining technical techniques disclosed in different embodiments are also included in the technical scope of the present invention.

The present international application claims priority based on Japanese Patent Application No. 2022-200646, which is a Japanese patent application filed on December. 15, 2022, and all contents of Japanese Patent Application No. 2022-200646, which is the Japanese patent application, are incorporated in the present international application.

The above description of a specific embodiment of the present invention is presented for the purpose of illustration. The above description is not intended to be exhaustive or to limit the present invention to the described aspects as they are. It is apparent to those skilled in the art that many modifications and changes can be made in light of the above description.

### REFERENCE SIGNS LIST

100, 200: optical member
10: reflecting portion
20: lens portion
30: light emitting element
40: mounting substrate
11: body portion
12: reflecting surface
13: top surface
14: bottom surface
15: cavity
16: light emission port
17: light incident port
21: central region
21a, 22a: light incident surface
22: peripheral region
23: boundary portion
24: light emission surface
25: lens holding portion

## Claims

1. An optical member comprising:
a reflecting portion comprising a reflecting surface formed on an inner surface thereof, the reflecting portion having a light incident port opened at one end of the reflecting surface and a light emission port opened at another end of the reflecting surface; and
a lens portion disposed at the light emission port of the reflecting portion,
wherein the lens portion comprises a central region positioned at a center and a peripheral region provided around the central region, and an optical power of the central region is larger than that of the peripheral region.

2. The optical member according to claim 1,
wherein a distance D between the light emission port and the central region and a width Wₒᵤₜ of the light emission port satisfy a relation of D ≤ 0.5 Wₒᵤₜ.

3. The optical member according to claim 2,
wherein the central region has a convex lens shape in which a light incident surface protrudes toward the reflecting portion.

4. The optical member according to claim 3,
wherein at least a part of the light incident surface is inserted so as to be situated on a light incident port side relative to the light emission port.

5. The optical member according to claim 1,
wherein a width W_{c} of the central region and a width Wₒᵤₜ of the light emission port satisfy a relation of 0.3 Wₒᵤₜ ≤ W_{c} ≤ 0.7 Wₒᵤₜ.

6. The optical member according to claim 1,
wherein the reflecting surface has a polygonal cross section.

7. The optical member according to claim 1,
wherein a plurality of sets, each of the plurality of sets comprising the reflecting portion and the lens portion, are provided, and the plurality of sets of reflecting portions and lens portions are connected and arranged in a uniaxial direction.

8. An illumination device comprising:
the optical member according to any one of claims 1 to 7; and
a light emitting element disposed on a light incident port side and configured to emit light,
wherein a width W_{d} of the light emitting element and a width Wᵢₙ of the light incident port satisfy a relation of W_{d} < Wᵢₙ.

9. An image projection device comprising:
the illumination device according to claim 8;
an image display unit configured to display an image by being irradiated with the light from the illumination device; and
a projection optical unit configured to project the light from the image display unit.
